# EUROPEAN PATENT APPLICATION

(11) **EP 2 806 112 A1**
(43) Date of publication of application: **26.11.2014**
(21) Application number: 12864642.9
(22) Date of filing: 27.12.2012
(51) Int. Cl.: F01D 15/10, F01D 17/00, F01D 21/00, F01D 25/00, G01R 31/02, H02H 3/34, H02H 3/40, H02J 3/26

(54) **POWER LOAD IMBALANCE DETECTION DEVICE AND POWER LOAD IMBALANCE DETECTION METHOD**

(30) Priority: 05.01.2012 JP 2012000752
(71) Applicant: Kabushiki Kaisha Toshiba, Minato-ku Tokyo 105-8001 (JP)
(72) Inventor: IKEJIRI, Satoshi, Minato-ku, Tokyo 105-8001 (JP); ISHIKAWA, Takashi, Minato-ku, Tokyo 105-8001 (JP); KATAOKA, Kazuyoshi, Minato-ku, Tokyo 105-8001 (JP)
(74) Representative: Granleese, Rhian Jane
(86) International application number: PCT/JP2012/008404
(87) International publication number: WO 2013/102990

(57) **Abstract**

First through third phase voltage level determiners (30-32) output signals , respectively, when any of the first through third phase impedance values fall below a reference value among the three phase voltages representing transmission grid voltages. When an output signal is received from all of the determiners, a grid fault detecting AND circuit (33) outputs a grid fault detection signal indicating that a major grid fault has occurred among the various types of grid faults that may occur. A rate-of-change detector (19) outputs a rate-of-change detection signal when the change in the value of a generator end current (18) exceeds a given set value. A logic circuit (46), which includes an OR circuit (23) and an AND circuit (24), outputs inflowing steam flow-rate reduction signals (26) based on grid fault detection signals or rate-of-change detection signals.

## Description

### TECHNICAL FIELD

Embodiments of the invention relate to a power load imbalance detection device and a power load imbalance detection method in a steam turbine plant.

### BACKGROUND ART

In a steam turbine plant, a turbine generator (hereinafter, referred to as a generator) balances inflowing steam energy (acceleration energy) and emitting electric energy (deceleration energy) during normal operation to control a turbine rotation speed constant. For this reason, if a grid load is eliminated during operation of the generator, deceleration energy is eliminated and acceleration energy is accumulated. If the accumulated amount of acceleration energy increases, a phase difference angle inside the generator increases, and it becomes impossible to maintain the synchronization of the generator and the transmission grid. Therefore, in the steam turbine plant, a power load imbalance detection device which detects a rapid decrease in load of the generator is provided.

The events where the load of the generator rapidly decreases are broadly divided into two types of types of events. The first event is load cut-off caused by erroneous opening of the main circuit breaker, or the like, and in this event, the transmission grid voltage is not changed, and the generator end current becomes zero. The second type of events is a fault (grid fault) of the transmission grid caused by a ground fault or a short-circuit fault of the transmission line due to lightening or the like, and in this type of events, the transmission grid voltage decreases and the generator end current increases. However, in Japanese standard, the severest possible grid fault is an event that the transmission grid voltage decreases to about 20 % and the voltage is recovered after 200 ms duration, and under this condition, the generator can maintain synchronization with a transmission network without special operation. For this reason, it is not necessary to detect a grid fault in the generator.

Therefore, in order to only detect load cut-off without detecting a grid fault, a power load imbalance detection device of the related art detects a decrease in generator end current to determine the presence or absence of a rapid decrease in load. When it is determined to be a rapid decrease in load, the power load imbalance detection device outputs an inflow steam flow-rate reduction signal to a valve of the entrance of the steam turbine as a signal for closing the valve. The valve is rapidly closed in response to the inflow steam flow-rate reduction signal.

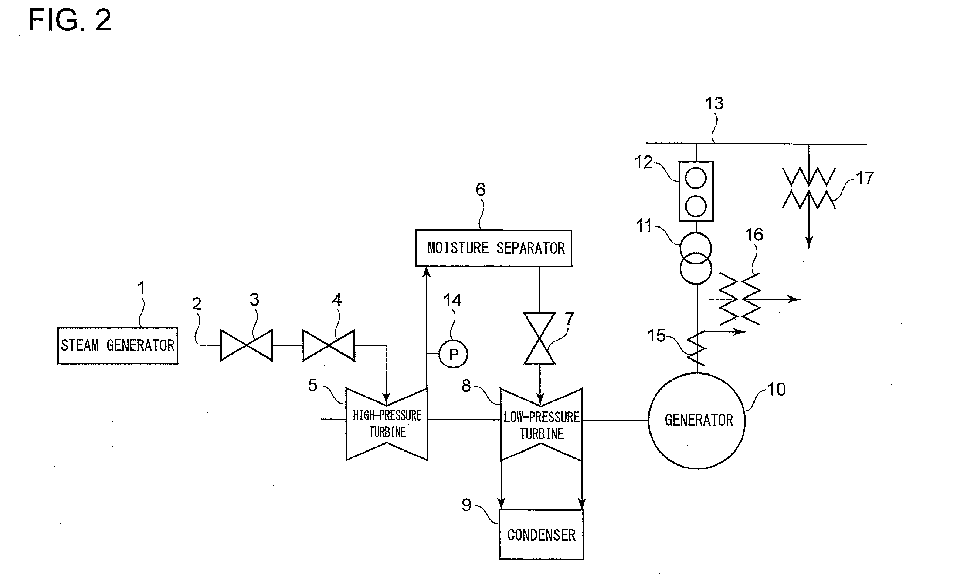

FIG. 2 is a grid schematic diagram illustrating a steam turbine plant.

A steam turbine plant includes: a high-pressure turbine 5 and a low-pressure turbine 8 as the above-described steam turbine, a main steam stop valve 3 and an intercept valve 7 as the above-described valve, a steam generator 1, a main steam pipe 2, a main steam control valve 4, a moisture separator 6, a condenser 9, a generator 10, a main transformer 11, a main circuit breaker 12, a transmission grid 13, a manometer 14, a generator end current detector 15 as a current detector (Current Transformer (CT)), and a generator end voltage detector 16 and a transmission grid voltage detector 17 as an instrument transformer (Potential Transformer (PT)) for voltage detection.

Steam generated by the steam generator 1 is sent to the high-pressure turbine 5 through the main steam pipe 2, the main steam stop valve 3, and the main steam control valve 4. The high-pressure turbine 5 converts part of thermal energy of steam to mechanical energy, and thereafter, steam having passed through the high-pressure turbine 5 is sent to the low-pressure turbine 8 through the moisture separator 6 and the intercept valve 7. The low-pressure turbine 8 converts energy of steam to mechanical energy, and thereafter, steam having passed through the low-pressure turbine 8 is sent to the condenser 9. Mechanical energy obtained by the high-pressure turbine 5 and the low-pressure turbine 8 is converted to electric energy by the generator 10, and the electric energy is sent to the transmission grid 13 through the main transformer 11 and the main circuit breaker 12.

The manometer 14 is provided on the exit side of the high-pressure turbine 5. The manometer 14 measures the flow-rate of turbine steam as the flow-rate of steam having passed through the high-pressure turbine 5 by pressure, and the flow-rate of turbine steam is output as an output power value of the high-pressure turbine 5. The generator end current detector 15 and the generator end voltage detector 16 are provided on a downstream side of the generator 10. The generator end current detector 15 measures a generator end current representing a current of the output terminal of the generator 10 and outputs the generator end current value. The generator end voltage detector 16 measures a generator end voltage representing a voltage of the output terminal of the generator 10 and outputs the generator end voltage value. The transmission grid voltage detector 17 is provided in the transmission grid 13. The transmission grid voltage detector 17 measures a transmission grid voltage representing a voltage of the transmission grid 13, and outputs the transmission grid voltage value.

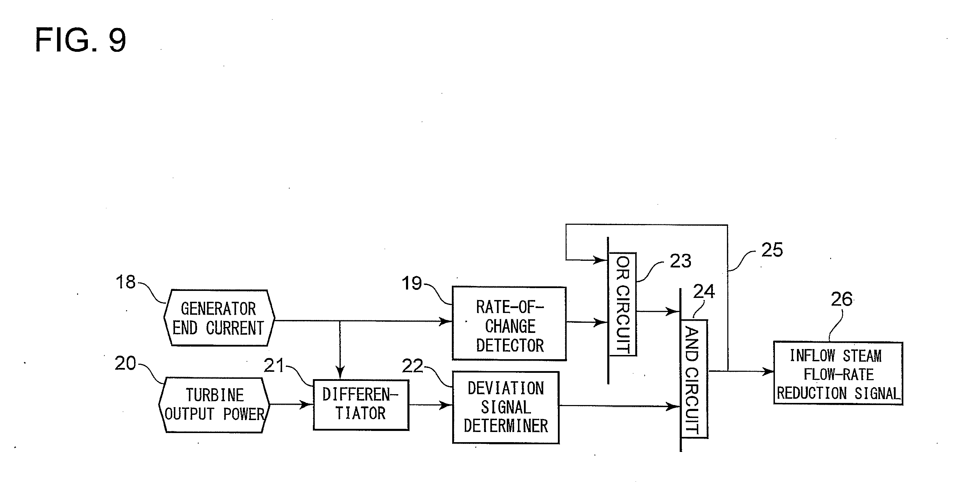

FIG. 9 is a block diagram illustrating the configuration of a power load imbalance detection device of the related art as the power load imbalance detection device described in Patent Document 1.

The power load imbalance detection device of the related art includes a rate-of-change detector 19, a differentiator 21, a deviation signal determiner 22, an OR circuit 23, and an AND circuit 24.

The rate-of-change detector 19 receives the above-described generator end current (generator end current 18) measured by the generator end current detector 15 as input, and monitors change in the value of the generator end current 18. When there is a change in the value of the generator end current 18 equal to or greater than a set value, the rate-of-change detector 19 outputs a rate-of-change detection signal representing this effect. The set value is obtained by subtracting a set generator end current value from the value of the generator end current 18 during normal state. That is, when the value of the generator end current 18 is equal to or smaller than the set generator end current value, the rate-of-change detector 19 outputs the rate-of-change detection signal. The level of the rate-of-change detection signal is HIGH level "1".

The differentiator 21 receives the generator end current 18 measured by the generator end current detector 15, and the output power (turbine output power 20) of the high-pressure turbine 5 measured by the manometer 14, as input. The differentiator 21 calculates the deviation between the value of the generator end current 18 and the value of the turbine output power 20.

The deviation signal determiner 22 receives the deviation calculated by the differentiator 21 as input. When a value representing the deviation is equal to or greater than a set deviation value, the deviation signal determiner 22 outputs a deviation determination signal representing this effect. The level of the deviation determination signal is HIGH level "1".

The OR circuit 23 outputs an output signal when any one signal of the rate-of-change detection signal "1" from the rate-of-change detector 19 and a power load imbalance signal 25 "1" from the AND circuit 24 is input. The level of the output signal is HIGH level "1".

When both the output signal "1" from the OR circuit 23 and the deviation determination signal "1" from the deviation signal determiner 22 are input, the AND circuit 24 outputs the above-described inflow steam flow-rate reduction signal (inflow steam flow-rate reduction signal 26) to the main steam control valve 4 on an upstream side of the high-pressure turbine 5 (the entrance of the high-pressure turbine 5) and the intercept valve 7 on an upstream side of the low-pressure turbine 8 (the entrance of the low-pressure turbine 8). In this case, the main steam control valve 4 and the intercept valve 7 are rapidly closed in response to the inflow steam flow-rate reduction signal 26 to reduce the inflow steam flow-rate into the turbine.

When both the output signal "1" from the OR circuit 23 and the deviation determination signal "1" from the deviation signal determiner 22 are input, the AND circuit 24 outputs the inflow steam flow-rate reduction signal 26 to the OR circuit 23 as the power load imbalance signal 25. The level of the power load imbalance signal 25 is HIGH level "1". For this reason, the output of the rate-of-change detector 19 is self-held.

In the power load imbalance detection device of the related art, the OR circuit 23 detects a decrease in the generator end current 18 by the rate-of-change detector 19, the deviation signal determiner 22 determines the presence or absence of a rapid decrease in load by the output of the differentiator 21. When the determination result represents a rapid decrease in load, the AND circuit 24 detects the occurrence of a load cut-off, and the inflow steam flow-rate reduction signal 26 is output. At this time, the main steam control valve 4 and the intercept valve 7 are rapidly closed in response to the inflow steam flow-rate reduction signal 26 to decrease the inflow steam flow-rate into the turbine. In this way, according to the power load imbalance detection device of the related art, it is possible to cope with load cut-off.

### CITATION LIST

### PATENT DOCUMENTS

Patent Document 1: Japanese Patent Application Laid-Open No. 2-67401
Patent Document 2: Japanese Patent Application Laid-Open No. 5-65805

### SUMMARY OF THE INVENTION

### PROBLEMS TO BE SOLVED BY THE INVENTION

Although it is not necessary to detect a grid fault outside a power plant, it is still necessary to detect load cut-off, hence, the power load imbalance detection device of the related art monitors the rate of decrease of the generator end current. The reason is that, even if the inflow steam flow-rate is not reduced in a possible grid fault in Japanese standard, the turbine generator can maintain synchronization with the transmission network, hence, it is not necessary to detect a grid fault.

However, in a grid standard of Northern Europe, even when a major grid fault, such as a three-phase ground fault or a three-phase short-circuit fault, in which the transmission grid voltage becomes 0 V, is continued for 250 ms or less, the maintenance of synchronization with the grid is required when the transmission grid voltage is returned. Under this condition, the effect of turbine acceleration by a grid fault is large, and in order for the generator to maintain synchronization with the grid, it is necessary to detect the occurrence of a grid fault quickly. Then, as the time spent in detecting a grid fault is shorter, it is possible to extend the grid fault time for which the turbine generator can maintain synchronization.

However, the types of grid faults include a major grid fault, such as a three-phase ground fault or a three-phase short-circuit fault, a frequent grid fault, such as a one-line ground fault or a two-line ground fault, in which reduction in inflow steam flow-rate is not required, and the like. When coping with a severe grid fault, such as a grid requirement of Northern Europe, if there is no distinction between a major grid fault and other grid faults, it is not desirable in terms of property protection.

In a technique described in Patent Document 2, as a method which detects a grid fault in the power load imbalance detection device, in addition to the generator end current, generator power (= load) is calculated from the generator end current and the generator end voltage, and the time rate of change of generator power is determined, thereby performing grid fault detection. According to this method, since there is no distinction between the types of grid faults, it is difficult to determine a three-line ground fault or short-circuit fault having a large amount of decrease in power, and a two-line short-circuit fault. The two-line short-circuit fault more frequently occurs than the three-line ground fault or short-circuit fault. If it is possible to determine the three-line ground fault or short-circuit fault and the two-line short-circuit fault, the number of special operations for a grid fault is reduced, hence, it is desirable in terms of property protection.

In this way, in order to cope with a severe grid fault, such as a grid requirement of Northern European standard, it is necessary to reliably determine the types of grid faults, and to detect a major grid fault among a plurality of types of grid faults quickly.

Accordingly, the problem to be solved by the invention is to cope with both a major grid fault and a load cut-off.

### MEANS FOR SOVING THE PROBLEMS

According to an embodiment, there is presented a power load imbalance detection device comprising:
a first phase impedance level determiner which calculates first phase impedance by dividing a first phase voltage value representing a first phase voltage of a three-phase voltage representing a voltage of a generator driven by a steam turbine by a first phase current value representing a first phase current of a three-phase current representing a current of the generator, and outputs an output signal when the first phase impedance value is equal to or smaller than an impedance reference value as a reference value;
a second phase impedance level determiner which calculates second phase impedance by dividing a second phase voltage value representing a second phase voltage of the three-phase voltage by a second phase current value representing a second phase current of the three-phase current, and outputs an output signal when the second phase impedance value is equal to or smaller than the impedance reference value;
a third phase impedance level determiner which calculates third phase impedance by dividing a third phase voltage value representing a third phase voltage of the three-phase voltage by a third phase current value representing a third phase current of the three-phase current, and outputs an output signal when the third phase impedance value is equal to or smaller than the impedance reference value; and
a grid fault detector which outputs a grid fault detection signal representing an occurrence of a major grid fault among a plurality of types of grid faults as a fault of a transmission grid when the output signals are received from all the first phase impedance level determiner, the second phase impedance level determiner, and the third phase impedance level determiner.

According to an embodiment, there is presented a power load imbalance detection method comprising:
a step of calculating first phase impedance by dividing a first phase voltage value representing a first phase voltage of a three-phase voltage representing a voltage of a generator driven by a steam turbine by a first phase current value representing a first phase current of a three-phase current representing a current of the generator, and outputting a first output signal when the first phase impedance value is equal to or smaller than an impedance reference value as a reference value;
a step of calculating second phase impedance by dividing a second phase voltage value representing a second phase voltage of the three-phase voltage by a second phase current value representing a second phase current of the three-phase current, and outputting a second output signal when the second phase impedance value is equal to or smaller than the impedance reference value;
a step of calculating third phase impedance by dividing a third phase voltage value representing a third phase voltage of the three-phase voltage by a third phase current value representing a third phase current of the three-phase current, and outputting a third output signal when the third phase impedance value is equal to or smaller than the impedance reference value; and
a step of outputting a grid fault detection signal representing an occurrence of a major grid fault among a plurality of types of grid faults as a fault of a transmission grid when all the first output signal, the second output signal, and the third output signal are received.

### ADVANTAGE OF THE INVENTION

According to the invention, it is possible to cope with both a major grid fault and a load cut-off.

### BRIEF DESCRIPTION OF THE DRAWINGS

FIG. 1 is a block diagram illustrating the configuration of a power load imbalance detection device according to a first embodiment.
FIG. 2 is a grid schematic diagram illustrating a steam turbine plant.
FIG. 3 is a schematic diagram illustrating an occurrence place of a grid fault.
FIG. 4 is a diagram illustrating voltage behavior at a fault point upon a grid fault.
FIG. 5 is a diagram illustrating voltage behavior at a voltage measurement point upon a grid fault.
FIG. 6 is a block diagram illustrating the configuration of a power load imbalance detection device according to a second embodiment.
FIG. 7 is a block diagram illustrating the configuration of a power load imbalance detection device according to a third embodiment.
FIG. 8 is a block diagram illustrating the configuration of a power load imbalance detection device according to a fourth embodiment.
FIG. 9 is a block diagram illustrating the configuration of a power load imbalance detection device of the related art as the power load imbalance detection device described in Patent Document 1.
FIG. 10 is a block diagram illustrating the configuration of a power load imbalance detection device according to a sixth embodiment.

### EMBODIMENTS FOR CARRYING OUT THE INVENTION

Hereinafter, embodiments of a power load imbalance detection device according to the invention will be described referring to the drawings. Here, the same or similar parts are represented by common reference numerals, and overlapping description will be omitted.

### [FIRST EMBODIMENT]

### (Configuration)

A power load imbalance detection device according to a first embodiment is applied to the above-described steam turbine plant. The steam turbine plant includes a steam turbine (a high-pressure turbine 5 and a low-pressure turbine 8), a valve (a main steam stop valve 3 and an intercept valve 7), a steam generator 1, a main steam pipe 2, a main steam control valve 4, a moisture separator 6, a condenser 9, a generator 10, a main transformer 11, a main circuit breaker 12, a transmission grid 13, a manometer 14, a generator end current detector 15, a generator end voltage detector 16, and a transmission grid voltage detector 17 (see FIG. 2).

The power load imbalance detection device according to the first embodiment is connected to the manometer 14, the generator end current detector 15, and the transmission grid voltage detector 17.

The manometer 14 measures a turbine steam flow-rate as the flow-rate of steam having passed through the high-pressure turbine 5 by pressure, and outputs the turbine steam flow-rate as an output power value of the high-pressure turbine 5. The generator end current detector 15 measures a generator end current 18 representing a current of the output terminal of the generator 10 and outputs the value.

The transmission grid voltage detector 17 measures a transmission grid voltage as a three-phase voltage representing a voltage of the transmission grid 13 and outputs the transmission grid voltage value.

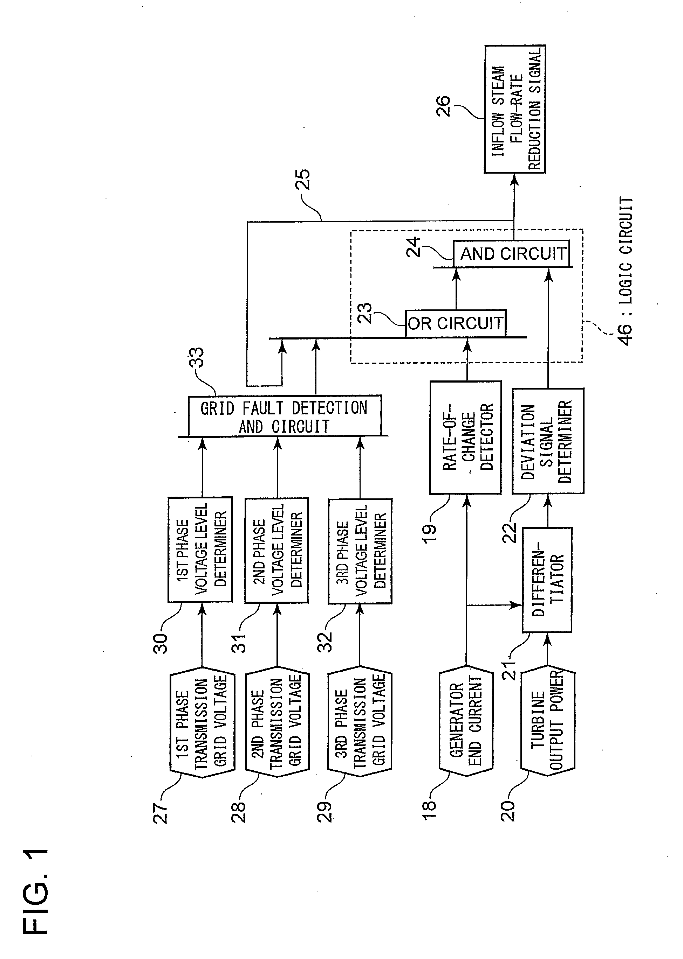

FIG. 1 is a block diagram illustrating the configuration of the power load imbalance detection device according to the first embodiment.

The power load imbalance detection device according to the first embodiment includes: a first phase voltage level determiner 30, a second phase voltage level determiner 31, a third phase voltage level determiner 32, a grid fault detection AND circuit (grid fault detector) 33, a rate-of-change detector 19, a differentiator 21, a deviation signal determiner 22, and a logic circuit 46. The logic circuit 46 includes an OR circuit 23 and an AND circuit 24.

That is, the power load imbalance detection device according to the first embodiment further includes the first phase voltage level determiner 30, the second phase voltage level determiner 31, the third phase voltage level determiner 32, and the grid fault detection AND circuit 33 compared to the power load imbalance detection device of the related art.

The first phase voltage level determiner 30, the second phase voltage level determiner 31, and the third phase voltage level determiner 32 hold a transmission grid voltage reference value as a preset reference value.

The first phase voltage level determiner 30 receives a first phase transmission grid voltage 27 representing a first phase voltage of the transmission grid voltage measured by the transmission grid voltage detector 17 as input. The first phase voltage level determiner 30 outputs an output signal "1" when the value of the first phase transmission grid voltage 27 is equal to or smaller than the transmission grid voltage reference value.

The second phase voltage level determiner 31 receives a second phase transmission grid voltage 28 representing a second phase voltage of the transmission grid voltage measured by the transmission grid voltage detector 17 as input. The second phase voltage level determiner 31 outputs an output signal "1" when the value of the second phase transmission grid voltage 28 is equal to or smaller than the transmission grid voltage reference value.

The third phase voltage level determiner 32 receives a third phase transmission grid voltage 29 representing a third phase voltage of the transmission grid voltage measured by the transmission grid voltage detector 17 as input. When the value of the third phase transmission grid voltage 29 is equal to or smaller than the transmission grid voltage reference value, the third phase voltage level determiner 32 outputs an output signal "1" representing this effect.

The input of the grid fault detection AND circuit 33 is connected to the outputs of the first phase voltage level determiner 30, the second phase voltage level determiner 31, and the third phase voltage level determiner 32. When the output signals "1" are received from all the first phase voltage level determiner 30, the second phase voltage level determiner 31, and the third phase voltage level determiner 32, the grid fault detection AND circuit 33 outputs a grid fault detection signal representing the occurrence of a major grid fault among a plurality of types of grid faults as a fault of the transmission grid 13. The level of the grid fault detection signal is HIGH level "1".

The rate-of-change detector 19 receives the generator end current 18 measured by the generator end current detector 15 as input. When there is a change in the value of the generator end current 18 equal to or greater than a set value, the rate-of-change detector 19 outputs a rate-of-change detection signal representing this effect. The set value is obtained by subtracting a set generator end current value from the value of the generator end current 18 during normal state. That is, the rate-of-change detector 19 outputs the rate-of-change detection signal when the value of the generator end current 18 is equal to or smaller than the set generator end current value. The level of the rate-of-change detection signal is HIGH level "1".

The differentiator 21 receives the generator end current 18 measured by the generator end current detector 15 and the output power (turbine output power 20) of the high-pressure turbine 5 measured by the manometer 14 as input. The differentiator 21 calculates the deviation between the value of the generator end current 18 and the value of the turbine output power 20.

The deviation signal determiner 22 receives the deviation calculated by the differentiator 21 as input. When a value representing the deviation is equal to or greater than a set deviation value, the deviation signal determiner 22 outputs a deviation determination signal representing this effect. The level of the deviation determination signal is HIGH level "1".

The OR circuit 23 outputs an output signal when any one of the grid fault detection signal "1", the rate-of-change detection signal "1", and the power load imbalance signal 25 "1" is input. The level of the output signal is HIGH level "1".

When both the output signal "1" from the OR circuit 23 and the deviation determination signal "1" from the deviation signal determiner 22 are input, the AND circuit 24 outputs an inflow steam flow-rate reduction signal 26 as a signal for closing the main steam control valve 4 and the intercept valve 7 to the main steam control valve 4 provided on the upstream side of the high-pressure turbine 5 (the entrance of the high-pressure turbine 5) and the intercept valve 7 provided on the upstream side of the low-pressure turbine 8 (the entrance of the low-pressure turbine 8). In this case, the main steam control valve 4 and the intercept valve 7 are rapidly closed in response to the inflow steam flow-rate reduction signal 26 to reduce an inflow steam flow-rate into the turbine.

When both the output signal "1" from the OR circuit 23 and the deviation determination signal "1" from the deviation signal determiner 22 are input, the AND circuit 24 outputs the inflow steam flow-rate reduction signal 26 to the OR circuit 23 as the power load imbalance signal 25. The level of the power load imbalance signal 25 is HIGH level "1". For this reason, the output of the rate-of-change detector 19 is self-held.

### (Operation)

The types of grid faults include a major grid fault, such as a three-phase ground fault or a three-phase short-circuit fault, and a frequent grid fault, such as a one-line ground fault or a two-line ground fault, in which reduction in inflow steam flow-rate is not required.

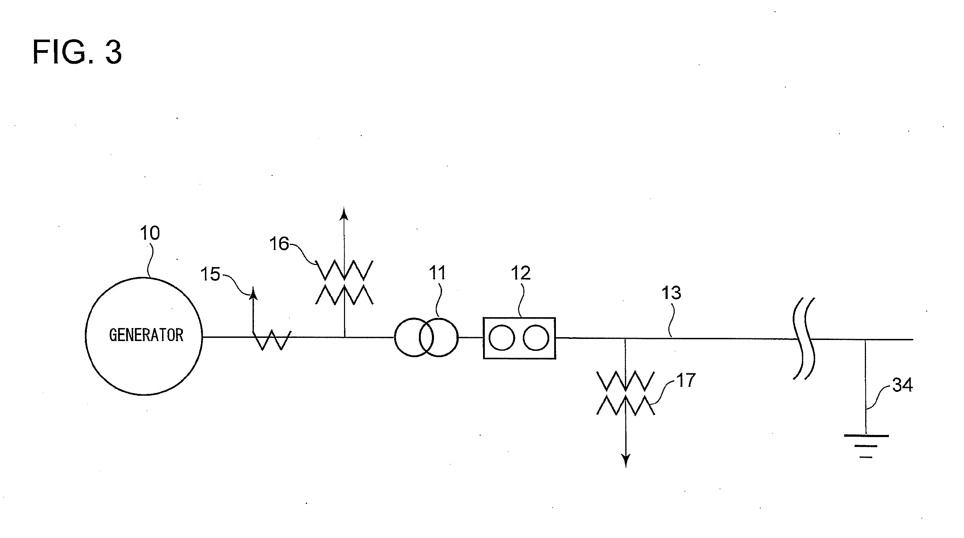

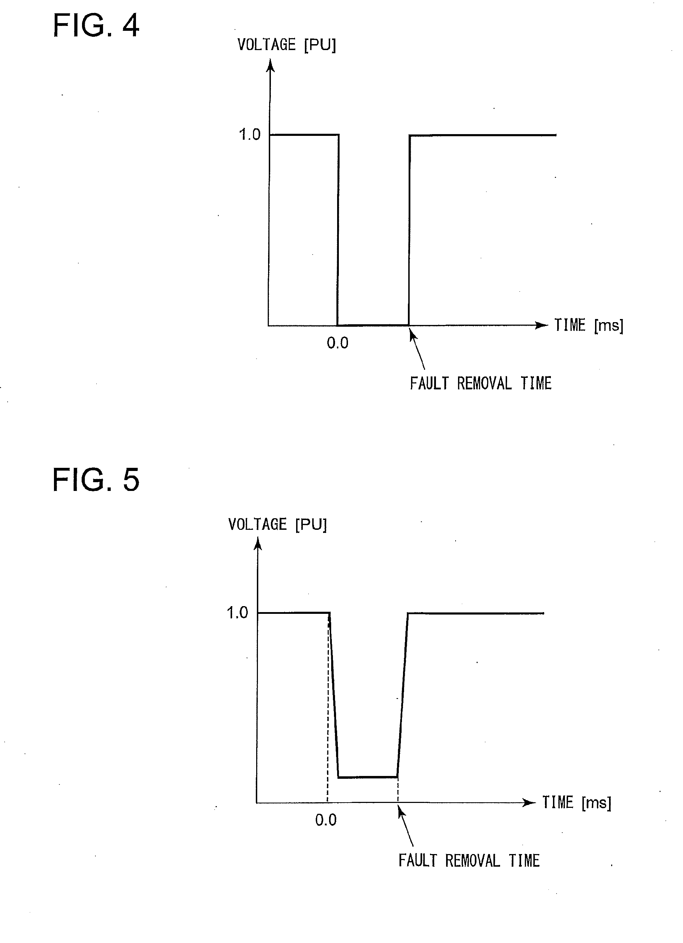

First, a case where a major grid fault, such as a three-phase ground fault or a three-phase short-circuit fault, occurs will be described. FIG. 3 is a schematic diagram illustrating an occurrence place of a grid fault. FIG. 4 is a diagram illustrating voltage behavior at a fault point upon a grid fault. FIG. 5 is a diagram illustrating voltage behavior at a voltage measurement point upon a grid fault.

When a major grid fault, such as a three-phase ground fault or a three-phase short-circuit fault, occurs at a fault point 34 shown in FIG. 3, the transmission grid voltage at the fault point 34 decreases as shown in FIG. 4 for the time period (fault removal time period) from the time when a fault occurs until the time the fault is removed. For the fault removal time period, all phases of the transmission grid voltage measured by the transmission grid voltage detector 17, that is, the first phase transmission grid voltage 27, the second phase transmission grid voltage 28, and the third phase transmission grid voltage 29 decrease as shown in FIG. 5. For this reason, when a fault occurs in the first phase, the second phase, and the third phase of the transmission grid 13, each of the first phase transmission grid voltage 27, the second phase transmission grid voltage 28, and the third phase transmission grid voltage 29 becomes smaller than the voltage during normal state, and when the value becomes equal to or smaller than the transmission grid voltage reference value, each of the first phase voltage level determiner 30, the second phase voltage level determiner 31, and the third phase voltage level determiner 32 detects the decrease in each of the first phase transmission grid voltage 27, the second phase transmission grid voltage 28, and the third phase transmission grid voltage 29, and outputs the output signal "1". Since the output signals "1" are output from all the first phase voltage level determiner 30, the second phase voltage level determiner 31, and the third phase voltage level determiner 32, the grid fault detection signal "1" representing the occurrence of a major grid fault among a plurality of types of grid faults is output from the grid fault detection AND circuit 33 to the OR circuit 23.

Next, a case where a frequent grid fault, such as a one-line ground fault or a two-line ground fault, occurs, in which reduction in inflow steam flow-rate is not required, will be described.

When a two-line ground fault or a two-line short-circuit fault occurs, two phase transmission grid voltages of the three-phase transmission grid voltage decrease and one normal phase transmission grid voltage is maintained. For example, when a fault occurs in the first phase and the second phase of the transmission grid 13, each of the first phase transmission grid voltage 27 and the second phase transmission grid voltage 28 becomes smaller than the voltage during normal state. When the value becomes equal to or smaller than the transmission grid voltage reference value, each of the first phase voltage level determiner 30 and the second phase voltage level determiner 31 detects the decrease in each of the first phase transmission grid voltage 27 and the second phase transmission grid voltage 28, and outputs the output signal "1". However, since the third phase transmission grid voltage 29 is maintained to the voltage during normal state, the output signal "1" is not output from the third phase voltage level determiner 32. That is, the level of the output signal of the third phase voltage level determiner 32 remains "0". For this reason, the grid fault detection signal "1" is not output from the grid fault detection AND circuit 33. In a case where a fault occurs in the second phase and the third phase of the transmission grid 13, and in a case where a fault occurs in the first phase and the third phase of the transmission grid 13, similar behavior as a case where a fault occurs in the first phase and the second phase of the transmission grid 13 is exhibited.

When a one-line ground fault occurs, one phase transmission grid voltage of the three-phase transmission grid voltage significantly decreases and two normal phase transmission grid voltages are maintained. For example, when a fault occurs in the first phase of the transmission grid 13, the first phase transmission grid voltage 27 becomes smaller than the voltage during normal state, and when the value becomes equal to or smaller than the transmission grid voltage reference value, the first phase voltage level determiner 30 detects the decrease in the first phase transmission grid voltage 27 and outputs the output signal "1". However, since each of the second phase transmission grid voltage 28 and the third phase transmission grid voltage 29 is maintained to the voltage during normal state, the output signals "1" are output from neither the second phase voltage level determiner 31 nor the third phase voltage level determiner 32. That is, the level of the output signal of each of the second phase voltage level determiner 31 and the third phase voltage level determiner 32 remains "0". For this reason, the grid fault detection signal "1" is not output from the grid fault detection AND circuit 33. In a case where a fault occurs only in the second phase of the transmission grid 13, or in a case where a fault occurs only in the third phase of the transmission grid 13, similar behavior as a case where a fault occurs only in the first phase of the transmission grid 13 is exhibited.

### (Effect)

As described above, in the power load imbalance detection device according to the first embodiment, each of the first phase voltage level determiner 30, the second phase voltage level determiner 31, and the third phase voltage level determiner 32 determines whether or not a fault has occurred in each phase of the transmission grid 13, and when the determination result represents that faults have occurred in all phases of the transmission grid 13, the grid fault detection AND circuit 33 detects the occurrence of a major grid fault among a plurality of types of grid faults. In this way, according to the power load imbalance detection device of the first embodiment, it is possible to reliably determine the types of grid faults and to detect only a major grid fault among a plurality of types of grid faults quickly.

In the power load imbalance detection device according to the first embodiment, the OR circuit 23 detects the decrease in the generator end current 18 by the rate-of-change detector 19, the deviation signal determiner 22 determines the presence or absence of a rapid decrease in load by the differentiator 21, when the determination result represents a rapid decrease in load, the AND circuit 24 detects the occurrence of a load cut-off, and the inflow steam flow-rate reduction signal 26 is output. At this time, the main steam control valve 4 and the intercept valve 7 are rapidly closed in response to the inflow steam flow-rate reduction signal 26 to decrease the inflow steam flow-rate into the turbine. In this way, according to the power load imbalance detection device of the first embodiment, it is possible to cope with load cut-off.

In the power load imbalance detection device according to the first embodiment, the OR circuit 23 detects at least one of the occurrence of a major grid fault and the decrease in the generator end current 18, the deviation signal determiner 22 determines the presence or absence of load cut-off by the differentiator 21, when the determination result represents a rapid decrease in load, the AND circuit 24 detects at least one of the occurrence of a major grid fault and the occurrence of a load cut-off, and the inflow steam flow-rate reduction signal 26 is output. At this time, the main steam control valve 4 and the intercept valve 7 are rapidly closed in response to the inflow steam flow-rate reduction signal 26 to decrease the inflow steam flow-rate into the turbine. In this way, according to the power load imbalance detection device of the first embodiment, it is possible to cope with both a major grid fault and a load cut-off.

### [SECOND EMBODIMENT]

In regard to a second embodiment, only changes from the first embodiment will be described. Portions which are not particularly described here are the same as those in the first embodiment.

### (Configuration)

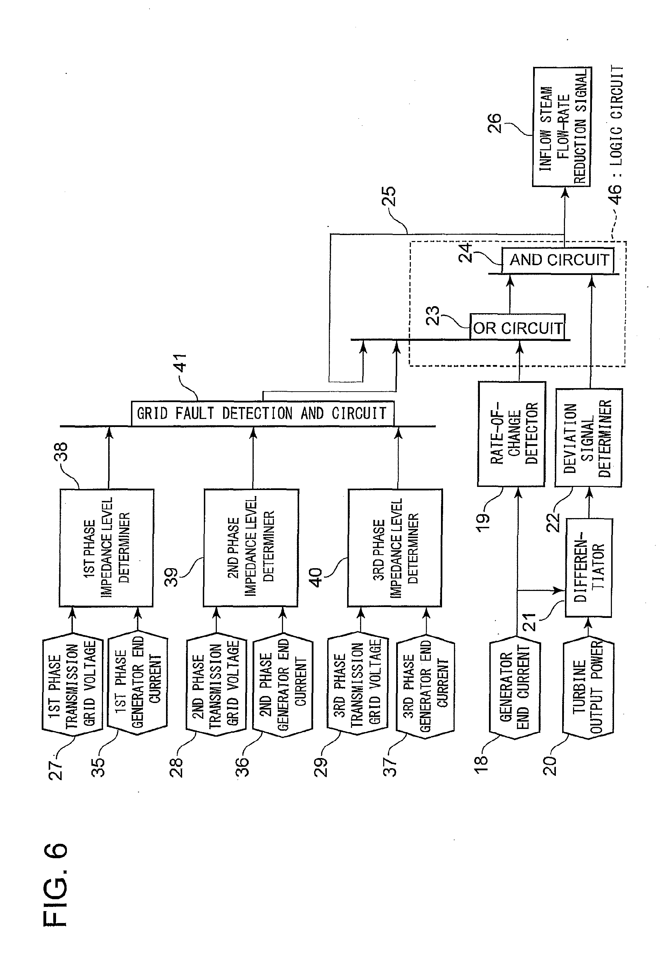

FIG. 6 is a block diagram illustrating the configuration of a power load imbalance detection device according to a second embodiment.

The power load imbalance detection device according to the second embodiment includes a first phase impedance level determiner 38, a second phase impedance level determiner 39, a third phase impedance level determiner 40, a grid fault detection AND circuit (grid fault detector) 41, a rate-of-change detector 19, a differentiator 21, a deviation signal determiner 22, and a logic circuit 46 (an OR circuit 23 and an AND circuit 24).

That is, the power load imbalance detection device according to the second embodiment includes the first phase impedance level determiner 38, the second phase impedance level determiner 39, the third phase impedance level determiner 40, and the grid fault detection AND circuit 41, instead of the first phase voltage level determiner 30, the second phase voltage level determiner 31, the third phase voltage level determiner 32, and the grid fault detection AND circuit 33 of the power load imbalance detection device according to the first embodiment.

The first phase impedance level determiner 38, the second phase impedance level determiner 39, and the third phase impedance level determiner 40 hold an impedance reference value as a preset reference value.

The first phase impedance level determiner 38 receives a first phase transmission grid voltage 27 representing a first phase voltage of the transmission grid voltage measured by the transmission grid voltage detector 17 and a first phase generator end current 35 representing a first phase current of the generator end current 18 measured by the generator end current detector 15 as input. The first phase impedance level determiner 38 calculates first phase impedance by dividing the value of the first phase transmission grid voltage 27 by the value of the first phase generator end current 35. The first phase impedance level determiner 38 outputs an output signal "1" when the first phase impedance value is equal to or smaller than the impedance reference value.

The second phase impedance level determiner 39 receives a second phase transmission grid voltage 28 representing a second phase voltage of the transmission grid voltage measured by the transmission grid voltage detector 17 and a second phase generator end current 36 representing a second phase current of the generator end current 18 measured by the generator end current detector 15 as input. The second phase impedance level determiner 39 calculates second phase impedance by dividing the value of the second phase transmission grid voltage 28 by the value of the second phase generator end current 36. The second phase impedance level determiner 39 outputs an output signal "1" when the second phase impedance value is equal to or smaller than the impedance reference value.

The third phase impedance level determiner 40 receives a third phase transmission grid voltage 29 representing a third phase voltage of the transmission grid voltage measured by the transmission grid voltage detector 17 and a third phase generator end current 37 representing a third phase current of the generator end current 18 measured by the generator end current detector 15 as input. The third phase impedance level determiner 40 calculates third phase impedance by dividing the value of the third phase transmission grid voltage 29 by the value of the third phase generator end current 37. The third phase impedance level determiner 40 outputs an output signal "1" when the third phase impedance value is equal to or smaller than the impedance reference value.

The input of the grid fault detection AND circuit 41 is connected to the outputs of the first phase impedance level determiner 38, the second phase impedance level determiner 39, and the third phase impedance level determiner 40. When the output signals "1" are received from all the first phase impedance level determiner 38, the second phase impedance level determiner 39, and the third phase impedance level determiner 40, the grid fault detection AND circuit 41 outputs a grid fault detection signal representing the occurrence of a major grid fault among a plurality of types of grid faults as a fault of the transmission grid 13. The level of the grid fault detection signal is HIGH level "1".

### (Operation)

First, a case where a major grid fault, such as a three-phase ground fault or a three-phase short-circuit fault, occurs will be described.

When a major grid fault, such as a three-phase ground fault or a three-phase short-circuit fault, occurs, the first phase transmission grid voltage 27, the second phase transmission grid voltage 28, and the third phase transmission grid voltage 29 decrease, and the first phase generator end current 35, the second phase generator end current 36, and the third phase generator end current 37 increase. Since impedance is voltage divided by current, the first phase impedance, the second phase impedance, and the third phase impedance decrease. For this reason, when faults occur in the first phase, the second phase, and the third phase of the transmission grid 13, the first phase impedance, the second phase impedance, and the third phase impedance become smaller than impedance during normal state, and when the value becomes equal to or smaller than the impedance reference value, each of the first phase impedance level determiner 38, the second phase impedance level determiner 39, and the third phase impedance level determiner 40 detects the decrease in each of the first phase impedance, the second phase impedance, and the third phase impedance, and outputs the output signal "1". Since the output signals "1" are output from all the first phase impedance level determiner 38, the second phase impedance level determiner 39, and the third phase impedance level determiner 40, the grid fault detection signal "1" representing the occurrence of a major grid fault among a plurality of types of grid faults is output from the grid fault detection AND circuit 41 to the OR circuit 23.

Next, a case where a frequent grid fault, such as a one-line ground fault or a two-line ground fault, occurs, in which reduction in inflow steam flow-rate is not required, will be described.

When a two-line ground fault or a two-line short-circuit fault occurs, two phase impedances of the three-phase impedance decrease and one normal phase impedance is maintained. For example, when faults occur only in the first phase and the second phase of the transmission grid 13, the first phase impedance and the second phase impedance become smaller than impedance during normal state, and when the value becomes equal to or smaller than the impedance reference value, each of the first phase impedance level determiner 38 and the second phase impedance level determiner 39 detects the decrease in each of the first phase impedance and the second phase impedance and outputs the output signal "1". However, since the third phase impedance is maintained to impedance during normal state, the output signal "1" is not output from the third phase impedance level determiner 40. That is, the level of the output signal of the third phase impedance level determiner 40 remains "0". For this reason, the grid fault detection signal "1" is not output from the grid fault detection AND circuit 41. In a case where faults occur in the second phase and the third phase of the transmission grid 13, and in a case where faults occur in the first phase and the third phase of the transmission grid 13, similar behavior as a case where faults occur in the first phase and the second phase of the transmission grid 13 is exhibited.

When a one-line ground fault occurs, one phase impedance of the three-phase impedance significantly decreases and two normal phase impedances are maintained. For example, when a fault occurs in the first phase of the transmission grid 13, the first phase impedance becomes smaller than impedance during normal state, and when the value becomes equal to or smaller than impedance, the first phase impedance level determiner 38 detects the decrease in the first phase impedance and outputs the output signal "1". However, since each of the second phase transmission grid voltage 28 and the third phase transmission grid voltage 29 is maintained to the voltage during normal state, the output signals "1" are output neigher from the second phase impedance level determiner 39 nor the third phase impedance level determiner 40. That is, the level of the output signal of each of the second phase impedance level determiner 39 and the third phase impedance level determiner 40 remains "0". For this reason, the grid fault detection signal "1" is not output from the grid fault detection AND circuit 41. In a case where a fault occurs in the second phase of the transmission grid 13, and in a case where a fault occurs in the third phase of the transmission grid 13, similar behavior as a case where a fault occurs in the first phase of the transmission grid 13 is exhibited.

In the detection of the three-phase impedance, in addition to the voltage and current of the transmission grid, the voltage and current of one of the transmission grid and the generator end may be measured.

### (Effect)

From the above description, in the power load imbalance detection device according to the second embodiment, each of the first phase impedance level determiner 38, the second phase impedance level determiner 39, and the third phase impedance level determiner 40 determines whether or not a fault occurs in each phase of the transmission grid 13, and when the determination result represents the occurrence of faults in all phases of the transmission grid 13, the grid fault detection AND circuit 41 detects the occurrence of a major grid fault among a plurality of types of grid faults. In this way, according to the power load imbalance detection device of the second embodiment, it is possible to reliably determine the types of grid faults and to detect only a major grid fault among a plurality of types of grid faults quickly.

According to the power load imbalance detection device of the second embodiment, since change in impedance is monitored, it is possible to determine the distance from the generator to the fault point.

If the distance from the generator to the fault point is long, since a transmission path to the fault point is long, an impedance drop upon a fault is small. If the transmission path to the fault point is long, since a load by the transmission path is large, over-speed of the generator is unlikely to occur.

In contrast, if the distance from the generator to the fault point is short, since the transmission path to the fault point is short, an impedance drop upon a fault is large. If the transmission path to the fault point is short, since a load by the transmission path is small, over-speed of the generator is likely to occur.

Accordingly, by comparing a three-phase impedance drop with a predetermined threshold value, when it is also necessary to prevent step-out (over-speed) of the generator, a signal can be output from the AND circuit 24.

In the power load imbalance detection device according to the second embodiment, as in the first embodiment, it is possible to cope with both a major grid fault and a load cut-off.

### [THIRD EMBODIMENT]

In regard to a third embodiment, only changes from the first embodiment will be described. Portions which are not particularly described here are the same as those in the first embodiment.

### (Configuration)

A power load imbalance detection device according to the third embodiment is connected to the generator end voltage detector 16, instead of the transmission grid voltage detector 17 in the first embodiment.

The generator end voltage detector 16 measures a generator end voltage as a three-phase voltage representing a voltage of the output terminal of the generator 10 and outputs the generator end voltage value.

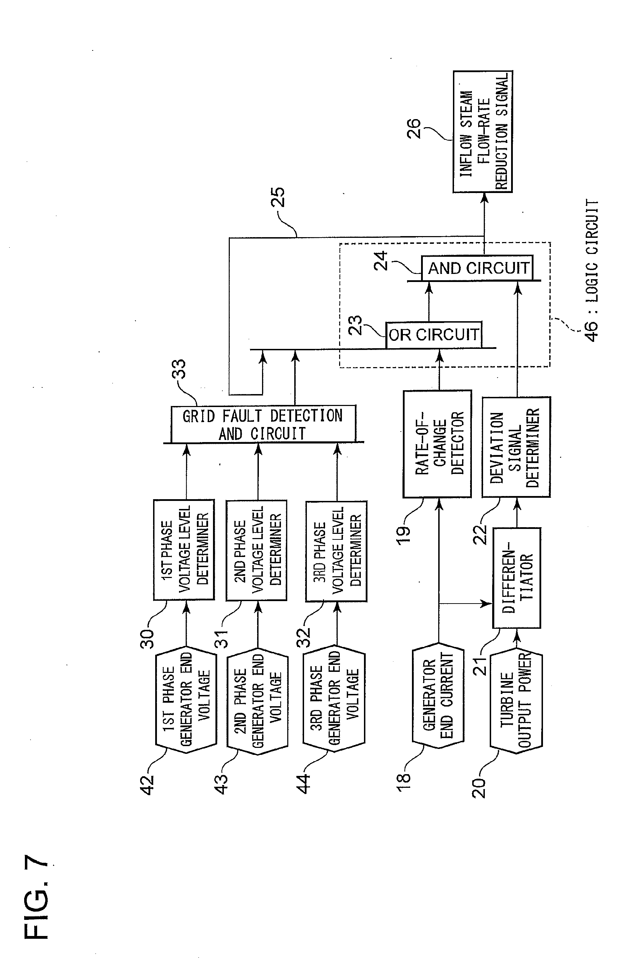

FIG. 7 is a block diagram illustrating the configuration of the power load imbalance detection device according to the third embodiment.

The power load imbalance detection device according to the third embodiment includes a first phase voltage level determiner 30, a second phase voltage level determiner 31, a third phase voltage level determiner 32, a grid fault detection AND circuit (grid fault detector) 33, a rate-of-change detector 19, a differentiator 21, a deviation signal determiner 22, and a logic circuit 46 (an OR circuit 23 and an AND circuit 24).

The first phase voltage level determiner 30, the second phase voltage level determiner 31, and the third phase voltage level determiner 32 hold a generator end voltage reference value as a preset reference value, instead of the transmission grid voltage reference value in the first embodiment.

The first phase voltage level determiner 30 receives a first phase generator end voltage 42 representing a first phase voltage of the generator end voltage measured by the generator end voltage detector 16 as input. The first phase voltage level determiner 30 outputs an output signal "1" when the value of the first phase generator end voltage 42 is equal to or smaller than the generator end voltage reference value.

The second phase voltage level determiner 31 receives a second phase generator end voltage 43 representing a second phase voltage of the generator end voltage measured by the generator end voltage detector 16 as input. The second phase voltage level determiner 31 outputs an output signal "1" when the value of the second phase generator end voltage 43 is equal to or smaller than the generator end voltage reference value.

The third phase voltage level determiner 32 receives a third phase generator end voltage 44 representing a third phase voltage of the generator end voltage measured by the generator end voltage detector 16 as input. When the value of the third phase generator end voltage 44 is equal to or smaller than the generator end voltage reference value, the third phase voltage level determiner 32 outputs an output signal "1" representing this effect.

The input of the grid fault detection AND circuit 33 is connected to the outputs of the first phase voltage level determiner 30, the second phase voltage level determiner 31, and the third phase voltage level determiner 32. When the output signals "1" are received from all the first phase voltage level determiner 30, the second phase voltage level determiner 31, and the third phase voltage level determiner 32, the grid fault detection AND circuit 33 outputs a grid fault detection signal representing the occurrence of a major grid fault among a plurality of types of grid faults as a fault of the transmission grid 13. The level of the grid fault detection signal is HIGH level "1".

### (Operation)

First, a case where a major grid fault, such as a three-phase ground fault or a three-phase short-circuit fault, occurs will be described.

When a major grid fault, such as a three-phase ground fault or a three-phase short-circuit fault, occurs, the first phase generator end voltage 42, the second phase generator end voltage 43, and the third phase generator end voltage 44 decrease. For this reason, when faults occur in the first phase, the second phase, and the third phase of the transmission grid 13, each of the first phase generator end voltage 42, the second phase generator end voltage 43, and the third phase generator end voltage 44 becomes smaller than the voltage during normal state, and when the value becomes equal to or smaller than the generator end voltage reference value, each of the first phase voltage level determiner 30, the second phase voltage level determiner 31, and the third phase voltage level determiner 32 detects the decrease in each of the first phase generator end voltage 42, the second phase generator end voltage 43, and the third phase generator end voltage 44 and outputs the output signal "1". Since the output signals "1" are output from all the first phase voltage level determiner 30, the second phase voltage level determiner 31, and the third phase voltage level determiner 32, the grid fault detection signal "1" representing the occurrence of a major grid fault among a plurality of types of grid faults is output from the grid fault detection AND circuit 33 to the OR circuit 23.

Next, a case where a frequent grid fault, such as a one-line ground fault or a two-line ground fault, occurs, in which reduction in inflow steam flow-rate is not required, will be described.

When a two-line ground fault or a two-line short-circuit fault occurs, two phase transmission grid voltages of the three-phase transmission grid voltage decrease and one normal phase transmission grid voltage is maintained. For example, when faults occur in the first phase and the second phase of the transmission grid 13, each of the first phase generator end voltage 42 and the second phase generator end voltage 43 becomes smaller than the voltage during normal state, and when the value becomes equal to or smaller than the transmission grid voltage reference value, each of the first phase voltage level determiner 30 and the second phase voltage level determiner 31 detects the decrease in each of the first phase generator end voltage 42 and the second phase generator end voltage 43 and outputs the output signal "1". However, since the third phase generator end voltage 44 is maintained to the voltage during normal state, the output signal "1" is not output from the third phase voltage level determiner 32. That is, the level of the output signal of the third phase voltage level determiner 32 remains "0". For this reason, the grid fault detection signal "1" is not output from the grid fault detection AND circuit 33. In a case where faults occur in the second phase and the third phase of the transmission grid 13, and in a case where faults occur in the first phase and the third phase of the transmission grid 13, similar behavior as a case where faults occur in the first phase and the second phase of the transmission grid 13 is exhibited.

When a one-line ground fault occurs, one phase transmission grid voltage of the three-phase transmission grid voltage significantly decreases and two normal phase transmission grid voltages are maintained. For example, when a fault occurs in the first phase of the transmission grid 13, the first phase generator end voltage 42 becomes smaller than the voltage during normal state, and when the value becomes equal to or smaller than the transmission grid voltage reference value, the first phase voltage level determiner 30 detects the decrease in the first phase generator end voltage 42 and outputs the output signal "1". However, since each of the second phase generator end voltage 43 and the third phase generator end voltage 44 is maintained to the voltage during normal state, the output signals "1" are not output from the second phase voltage level determiner 31 and the third phase voltage level determiner 32. That is, the level of the output signal of each of the second phase voltage level determiner 31 and the third phase voltage level determiner 32 remains "0". For this reason, the grid fault detection signal "1" is not output from the grid fault detection AND circuit 33. In a case where a fault occurs in the second phase of the transmission grid 13, and in a case where a fault occurs in the third phase of the transmission grid 13, similar behavior as a case where a fault occurs in the first phase of the transmission grid 13 is exhibited.

### (Effect)

From the above description, according to the power load imbalance detection device of the third embodiment, as in the first embodiment, it is possible to reliably determine the types of grid faults and to detect only a major grid fault among a plurality of types of grid faults quickly.

In the power load imbalance detection device according to the third embodiment, as in the first embodiment, it is possible to cope with both a major grid fault and a load cut-off.

### [FOURTH EMBODIMENT]

In regard to a fourth embodiment, only changes from the first embodiment will be described. Portions which are not particularly described here are the same as those in the first embodiment.

### (Configuration)

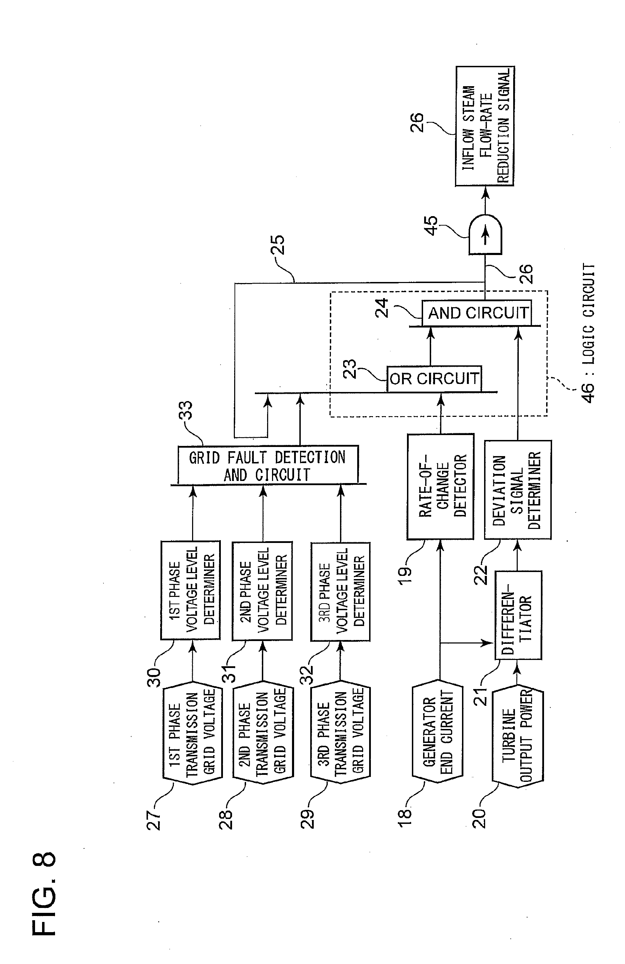

FIG. 8 is a block diagram illustrating the configuration of a power load imbalance detection device according to the fourth embodiment.

The power load imbalance detection device according to the fourth embodiment includes a first phase voltage level determiner 30, a second phase voltage level determiner 31, a third phase voltage level determiner 32, a grid fault detection AND circuit (a grid fault detector) 33, a rate-of-change detector 19, a differentiator 21, a deviation signal determiner 22, a logic circuit 46 (an OR circuit 23 and an AND circuit 24), and an on-delay timer circuit 45.

That is, the power load imbalance detection device according to the fourth embodiment further includes the on-delay timer circuit 45 compared to the power load imbalance detection device according to the first embodiment.

The on-delay timer circuit 45 is provided between the AND circuit 24 and the main steam control valve 4 and the intercept valve 7. The on-delay timer circuit 45 outputs the inflow steam flow-rate reduction signal 26 to the main steam control valve 4 and the intercept valve 7 only when the inflow steam flow-rate reduction signal 26 is continuously input from the AND circuit 24 until a set duration time elapses.

### (Operation)

In the power load imbalance detection device according to the fourth embodiment, when the AND circuit 24 detects at least one of the occurrence of a major grid fault and the occurrence of a load cut-off, the inflow steam flow-rate reduction signal 26 is output from the AND circuit 24 to the on-delay timer circuit 45. The on-delay timer circuit 45 starts counting when the inflow steam flow-rate reduction signal 26 is input from the AND circuit 24. When the inflow steam flow-rate reduction signal 26 is input until the set duration time (for example, 15 ms, 50 ms, or the like) elapses, the on-delay timer circuit 45 outputs the inflow steam flow-rate reduction signal 26 to the main steam control valve 4 and the intercept valve 7. At this time, the main steam control valve 4 and the intercept valve 7 are rapidly closed in response to the inflow steam flow-rate reduction signal 26 to decrease the inflow steam flow-rate into the turbine.

### (Effect)

From the above description, according to the power load imbalance detection device of the fourth embodiment, in addition to the effects of the first embodiment, it is possible to prevent an erroneous operation which is likely to occur due to instantaneous change in the three-phase voltage of the transmission grid 13.

Although in the power load imbalance detection device according to the fourth embodiment, the on-delay timer circuit 45 is added to the power load imbalance detection device according to the first embodiment, and only changes from the first embodiment have been described, the invention is not limited thereto. In the power load imbalance detection device according to the fourth embodiment, the on-delay timer circuit 45 may be added to the power load imbalance detection device according to the second embodiment or the third embodiment, thereby realizing the above-described effects.

### [FIFTH EMBODIMENT]

In regard to a fifth embodiment, only changes from the first embodiment or the fourth embodiment will be described. Portions which are not particularly described here are the same as those in the first embodiment or the fourth embodiment.

### (Configuration)

The transmission grid voltage reference value held by each of the first phase voltage level determiner 30, the second phase voltage level determiner 31, and the third phase voltage level determiner 32 is a value obtained by subtracting a value equal to or greater than an allowable voltage oscillation value from each phase transmission grid voltage value during normal state.

### (Operation)

The features of respective phase voltages at a fault point upon a grid fault are as follows. (1) In a one-line ground fault fault phase voltage becomes 0, and two normal phase voltages become about a multiple of root 3. (2) In a two-line ground fault, fault phase voltage becomes 0 in two phases, and the normal phase voltage becomes about 1.5 times. (3) In a two-line short-circuit fault, the fault phase voltage is about half the voltage during normal state in two phases, and a normal phase voltage is little changed. (4) In a three-line ground fault or in a three-lin short-circuit fault, the voltage decreases equally in three phases.

From the above, a grid fault in which the voltages in the three phases decrease compared to the voltage during normal state is only a three-line ground fault or short-circuit fault. However, since the voltages in the three phases decrease compared to the voltage during normal state due to voltage oscillation by grid shaking other than a grid fault, the transmission grid voltage reference value held by each of the first phase voltage level determiner 30, the second phase voltage level determiner 31, and the third phase voltage level determiner 32 is set to a value (for example, set to be equal to or smaller than 70% of the voltage during normal state) obtained by subtracting a value equal to or greater than allowable voltage oscillation upon grid shaking from the value of each phase transmission grid voltage during normal state, whereby only a three-line ground fault or a three-line short-circuit fault is detected without detecting grid shaking.

### (Effect)

From the above description, according to the power load imbalance detection device of the fifth embodiment, in addition to the effects of the first embodiment or the effects of the first embodiment and the fourth embodiment, it is possible to detect only a three-line ground fault or a three-line short-circuit fault without detecting grid shaking.

### [SIXTH EMBODIMENT]

In regard to a sixth embodiment, only changes from the first embodiment and the second embodiment will be described. Portions which are not particularly described here are the same as those in the first embodiment or the second embodiment.

### (Configuration)

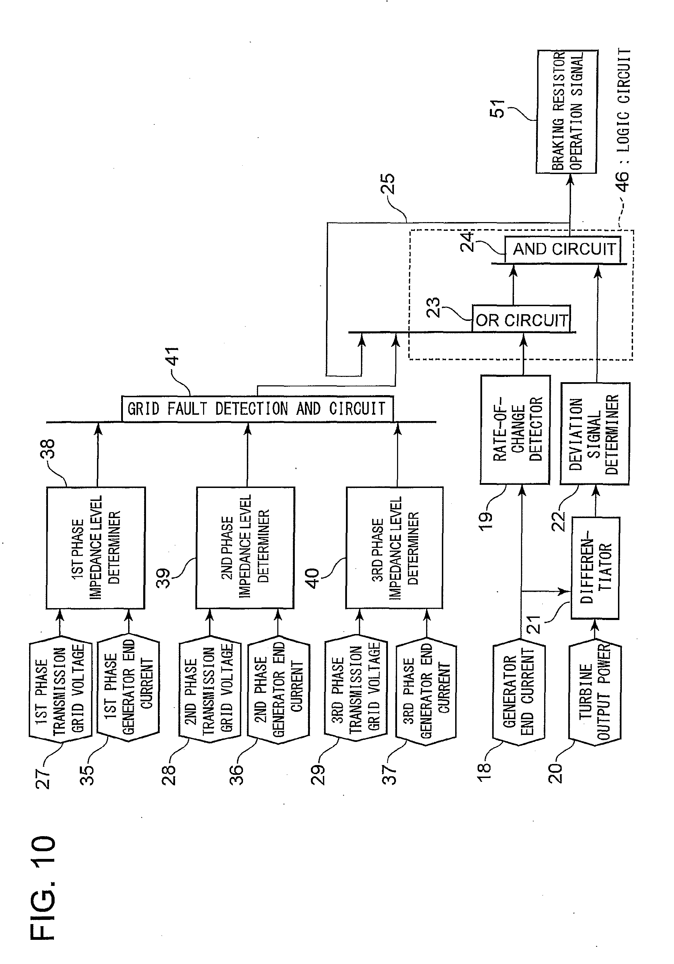

FIG. 10 is a block diagram illustrating the operation of a power load imbalance detection device according to the sixth embodiment. In this embodiment, the output signal of the AND circuit 24 is a braking resistor (SDR) operation signal 51, instead of the inflow steam flow-rate reduction signal 26.

A braking resistor (SDR: System Damping Resistor, not shown) is connected in series or in parallel to the generator 10. The braking resistor (SDR) is operated by a braking resistor control panel (not shown). The braking resistor (SDR) temporarily adds a resistive load to the generator, which is accelerated with the occurrence of a grid fault, to spend or emit an amount corresponding to mechanical acceleration energy of the generator as thermal energy. The braking resistor control panel is connected to receive a braking resistor (SDR) operation signal 51 from the AND circuit 24.

### (Operation)

In the power load imbalance detection device, when a major grid fault, in which the three-phase impedance decreases, is detected, the braking resistor (SDR) operation signal 51 is output from the AND circuit 24. When the braking resistor (SDR) operation signal 51 is received, the braking resistor control panel adds the braking resistor (SDR) in a current path of the generator 10. As a result, power generated by the generator 10 is spent by the braking resistor (SDR), whereby over-speed of the generator 10 by a grid fault is suppressed.

### (Effect)

As described above, according to the power load imbalance detection device of the sixth embodiment, it is possible to determine the type of grid fault, to rapidly detect only a major grid fault among a plurality of types of grid faults, and to operate the braking resistor (SDR) when a major grid fault occurred.

In the grid fault detection by the three-phase impedance as in the second embodiment, the braking resistor (SDR) can be added as described above. Alternatively, the output signal of grid fault detection by a three-phase voltage drop as in the first embodiment may be the braking resistor (SDR) operation signal 51.

### [OTHER EMBODIMENTS]

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

### [EXPLANATION OF SYMBOLIC NUMERALS]

- 1:: steam generator
- 2:: main steam pipe
- 3:: main steam stop valve
- 4:: main steam control valve
- 5:: high-pressure turbine
- 6:: moisture separator
- 7:: intercept valve
- 8:: low-pressure turbine
- 9:: condenser
- 10:: generator
- 11:: main transformer
- 12:: main circuit breaker
- 13:: transmission grid
- 14:: manometer
- 15:: generator end current detector
- 16:: generator end voltage detector
- 17:: transmission grid voltage detector
- 18:: generator end current
- 19:: rate-of-change detector
- 20:: turbine output power
- 21:: differentiator
- 22:: deviation signal determiner
- 23:: OR circuit
- 24:: AND circuit
- 25:: power load imbalance signal
- 26:: inflow steam flow-rate reduction signal
- 27:: first phase transmission grid voltage
- 28:: second phase transmission grid voltage
- 29:: third phase transmission grid voltage
- 30:: first phase voltage level determiner
- 31:: second phase voltage level determiner
- 32:: third phase voltage level determiner
- 33:: grid fault detection AND circuit (grid fault detector)
- 34:: fault point
- 35:: first phase generator end current
- 36:: second phase generator end current
- 37:: third phase generator end current
- 38:: first phase impedance level determiner
- 39:: second phase impedance level determiner
- 40:: third phase impedance level determiner
- 41:: grid fault detection AND circuit
- 42:: first phase generator end voltage
- 43:: second phase generator end voltage
- 44:: third phase generator end voltage
- 45:: on-delay timer circuit
- 46:: logic circuit
- 51:: braking resistor (SDR) operation signal

## Claims

1. A power load imbalance detection device comprising:
a first phase impedance level determiner which calculates first phase impedance by dividing a first phase voltage value representing a first phase voltage of a three-phase voltage representing a voltage of a generator driven by a steam turbine by a first phase current value representing a first phase current of a three-phase current representing a current of the generator, and outputs an output signal when the first phase impedance value is equal to or smaller than an impedance reference value as a reference value;
a second phase impedance level determiner which calculates second phase impedance by dividing a second phase voltage value representing a second phase voltage of the three-phase voltage by a second phase current value representing a second phase current of the three-phase current, and outputs an output signal when the second phase impedance value is equal to or smaller than the impedance reference value;
a third phase impedance level determiner which calculates third phase impedance by dividing a third phase voltage value representing a third phase voltage of the three-phase voltage by a third phase current value representing a third phase current of the three-phase current, and outputs an output signal when the third phase impedance value is equal to or smaller than the impedance reference value; and
a grid fault detector which outputs a grid fault detection signal representing an occurrence of a major grid fault among a plurality of types of grid faults as a fault of a transmission grid when the output signals are received from all the first phase impedance level determiner, the second phase impedance level determiner, and the third phase impedance level determiner.

2. The power load imbalance detection device according to claim 1, further comprising:
a logic circuit which outputs a braking resistor (SDR) operation signal for operating a braking resistor (SDR) connected to the generator on a basis of the grid fault detection signal.

3. The power load imbalance detection device according to claim 1, further comprising:
a logic circuit which outputs an inflow steam flow-rate reduction signal for closing a valve provided on an upstream side of the steam turbine to the valve on a basis of the grid fault detection signal.

4. The power load imbalance detection device according to claim 3, further comprising:
an on-delay timer circuit which outputs the inflow steam flow-rate reduction signal to the valve only when the inflow steam flow-rate reduction signal is continuously input from the logic circuit until a set duration time elapses.

5. The power load imbalance detection device according to any one of claims 2 to 4, further comprising:
a differentiator which calculates a deviation between a value of a generator end current and an output power value of the steam turbine; and
a deviation signal determiner which outputs a deviation determination signal when a value representing the deviation calculated by the differentiator is equal to or greater than a set deviation value,
wherein the logic circuit performs signal output on the basis of the grid fault detection signal and the deviation determination signal.

6. A power load imbalance detection method comprising:
a step of calculating first phase impedance by dividing a first phase voltage value representing a first phase voltage of a three-phase voltage representing a voltage of a generator driven by a steam turbine by a first phase current value representing a first phase current of a three-phase current representing a current of the generator, and outputting a first output signal when the first phase impedance value is equal to or smaller than an impedance reference value as a reference value;
a step of calculating second phase impedance by dividing a second phase voltage value representing a second phase voltage of the three-phase voltage by a second phase current value representing a second phase current of the three-phase current, and outputting a second output signal when the second phase impedance value is equal to or smaller than the impedance reference value;
a step of calculating third phase impedance by dividing a third phase voltage value representing a third phase voltage of the three-phase voltage by a third phase current value representing a third phase current of the three-phase current, and outputting a third output signal when the third phase impedance value is equal to or smaller than the impedance reference value; and
a step of outputting a grid fault detection signal representing an occurrence of a major grid fault among a plurality of types of grid faults as a fault of a transmission grid when all the first output signal, the second output signal, and the third output signal are received.
